Europäisches Patentamt

European Patent Office

Office européen des brevets

(11) Publication number: 0 584 436 A1

# EUROPEAN PATENT APPLICATION

(21) Application number: 92830455.9

(22) Date of filing: 26.08.92

(51) Int. Cl.5: **H01L 21/00**, H01L 21/266, H01L 21/74

(43) Date of publication of application:
02.03.94 Bulletin 94/09

(84) Designated Contracting States:
DE FR GB IT

(71) Applicant: **CO.RI.M.ME. CONSORZIO PER LA RICERCA SULLA MICROELETTRONICA NEL MEZZOGIORNO**
**Stradale Primosole, 50**
**I-95121 Catania(IT)**

(72) Inventor: **Zambrano, Raffaele**
**Via Duca d'Aosta, 43A**
**I-95037 San Giovanni La Punta (CT)(IT)**
Inventor: **Alberio, Francesco**
**Via Casale dei Greci, 36**
**I-95031 Adrano (CT)(IT)**

(74) Representative: **Checcacci, Giorgio**
**PORTA, CHECCACCI & BOTTI s.r.l.**
**Viale Sabotino, 19/2**
**I-20135 Milano (IT)**

(54) Process for forming buried regions, having different doping concentration, in monolitic semiconductor devices.

(57) The invention relates to a process for forming buried regions having different doping concentrations in monolithic semiconductor devices comprising at least one pair of electronic components which incorporate said regions. Such regions are formed simultaneously by a single phototechnique and implantation operation using partial masking or screening of the areas exposed to the implantation.

FIG.1

FIG.2

This invention relates to a process for forming buried regions, having different doping concentrations, in monolithic semiconductor devices which comprise at least one pair of electronic components incorporating said regions.

The field of application of this invention is particularly, but not solely, related to integrated control and/or power circuits, and reference will be made hereinafter to this field of application for convenience of illustration.

As is well-recognized, the process which leads to the formation of semiconductor integrated circuits requires that active areas or isolating regions be formed which, besides being structurally different one from the other, exhibit different concentrations of one dopant type.

Taking for example the case of a monolithic semiconductor device to be formed which comprises a control circuit, a high-voltage clamp diode, and a bipolar power transistor, the basic process steps that, in accordance with prior art techniques, are involved in the formation of such a device can be summarized as follows:
- growth of an epitaxial layer over a semiconductor substrate having a first doping;
- formation of a surface layer of thermal oxide; and
- photolithographic definition of a selected circuit pattern followed by chemical etching of the oxide layer and subsequent implantation of a second doping to define a horizontal isolating region for the control circuit.

At this stage, further discrete operations of phototechnique, oxide etching, and implantation of the second doping are performed to define a base region for an open-base bipolar transistor which functions as a high-voltage clamp diode. Likewise, another sequence of operations or steps of phototechnique, oxide etching, and implantation of the second doping are carried out to define the base region of the bipolar power transistor.

In essence, for each of the aforesaid components (control circuit, high-voltage clamp diode, power transistor), at least three process steps are applied to form discrete regions sharing the same second doping, which doping may, however, be present in different suitable concentrations for the individual components.

It will be appreciated that such a prior approach to the problem of forming said regions is quite a laborious one, because it requires that the same process steps be repeated for each of the regions.

Stated otherwise, each of said regions is formed independently of another in view of the different target concentration of one doping. It also occurs that the three successive steps of the phototechnique unavoidably result in the aforesaid regions being misaligned.

This makes the prior art process inefficiency even more serious.

The underlying technical problem of this invention is to provide a novel process for forming buried regions with different doping concentrations in semiconductor devices, which has such functional features as to overcome the drawbacks resulting from current embodiments proposed by the prior art solutions.

The solutive idea on which this invention stands is one of having the control circuit isolation region, the base region of the transistor with diode functions, and the base region of the bipolar power transistor, all formed simultaneously. Based on this solutive idea, the problem is solved by a process as indicated hereinabove and defined in the characterizing part of the appended claims.

Alternatively, in the process of this invention, the buried areas or regions of the semiconductor device may have the same doping concentration, since another type of doping would be employed in a second implantation step to obtain regions having different layer resistivities.

In this way, regions with different doping levels can be defined using the same implantation dosage of such another type of doping, again by altering the ratio of the surface area exposed to implantation to the overall surface area of one region.

This is made possible by that, for example, in order to obtain the same effects as would be provided by a lower-doped transistor base, slighter or heavier emitter doping can be resorted.

The features and advantages of a process according to the invention will be apparent from the following detailed description of an embodiment thereof, given with reference to the manufacturing steps for a monolithic semiconducor device shown in the accompanying drawings.

In the drawings:
Figures 1 to 4 are respective vertical section views showing schematically a monolithic semiconductor device formed by the process of this invention;
Figures 5 to 7 illustrate in schematic form alternative steps to those shown in Figures 1 to 3; and
Figure 8 is a schematic view of a mask employed in the process of this invention.

With reference to the drawing views, generally and schematically shown at 1 is a monolithically integrated, semiconductor electronic device formed by the process of this invention.

The device 1 is formed on a semiconductor silicon substrate 2 heavily doped N + .

An epitaxial layer 3 doped N- is grown over the substrate 2 which includes a protective isolating layer 4 of thermal oxide (SiO2).

The device 1 comprises a control circuit 5, an open-base transistor 6 functioning as a high-voltage clamp diode, and a bipolar power transistor 7.

To provide such components 5, 6 and 7, the process of this invention includes a starting photolithographic step, known per se, directed to define selected circuit patterns on the device 1 surface. This involves deposition of a photoresist layer 28 onto the device.

Specifically, by that photolithographic step, some areas are delimited which are respectively to form: a horizontal isolation region 25 for the driver 5, a base region 26 for the open-base transistor 6 with clamp diode functions, and a base region 27 for the bipolar power transistor 7.

Subsequent etching of the thermal oxide 4 enables the oxide 4 to be apertured as respectively shown at 15, 16 and 17, and the epitaxial layer 3 to be reached through said apertures to form said regions 25, 26 and 27 thereon.

At this point, in accordance with the invention, an ion-implantation step with a doping 22 agent of the P type is carried out.

This implantation step results in the regions 25, 26 and 27 being formed simultaneously by partial masking or screening of the respective areas being exposed to the implantation.

Briefly, during the implantation step, a single doping dose is used to produce regions with different doping concentrations by escluding the exposed area from the overall area of each of said regions 25, 26, 27.

The pattern of a mask which enables this step to be implemented will be described hereinafter.

It should be emphasized, however, that the inventive idea provides for a single sequence of phototechnique, oxide etching, and ion-implantation operations to simultaneously produce three discrete regions having different doping concentrations from one another; these regions being spatially and electrically isolated from one another.

In addition, such regions would be auto-aligned because of they being formed simultaneously, while the doping level ratio would be just dependent on the ratio between the exposed surface areas, not on the absolute values of the implanted dosages.

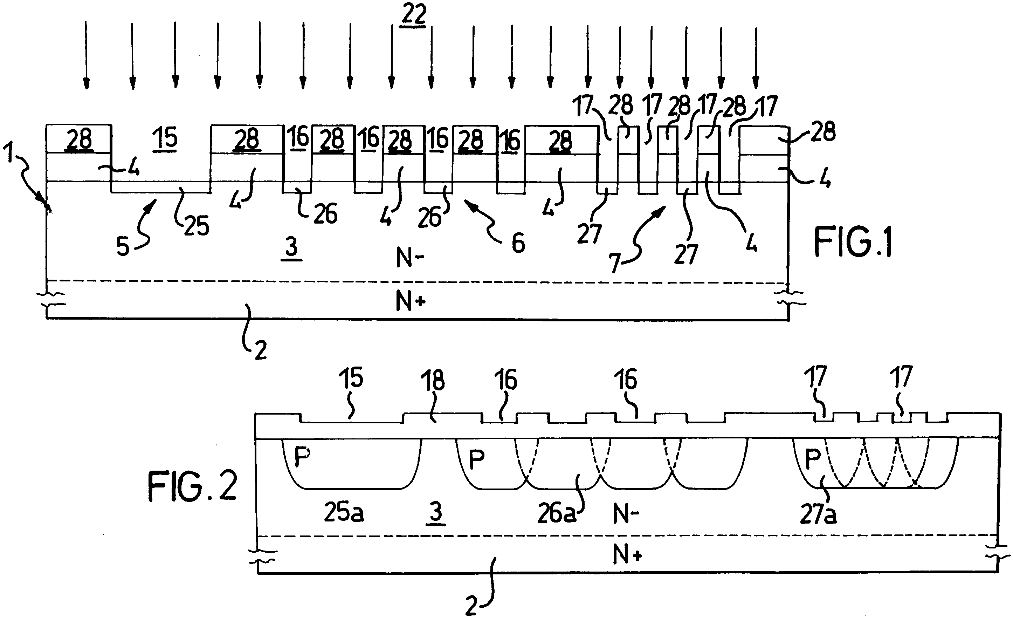

Figure 2 illustrates the structural evolution of the device 1 when subjected to successive steps of the inventive process, namely:

- removal of the photoresist layer 28;
- heat treatment for diffusing an aggregate of P-doped buried layers 25a, 26a, 27a corresponding to the implanted regions 25, 26, 27; and
- creation of a new surface layer 18 of silicon oxide.

During the diffusion step, the implanted regions -- that is, the horizontal isolation region 25 for the control circuit 5, region 26 on the high-voltage clamp diode 6, and region 27 on the bipolar power transistor 7 -- will diffuse to join one another and provide uniformly doped, diffused regions 25a, 26a and 27a.

The dose of the P-type doping used to make the device 1 varies within the range of $1*10^{13}$ ions/cm2 to $3*10^{14}$ ions/cm2.

Mention should be made, for completeness of discussion, of that the process of this invention would be carried further through subsequent steps which, although known already in the art, will be specified herein below.

A phototechnique step results in N-doped buried layers 13, 14, 19 being formed which relate to the control circuit 5, the high-voltage diode 6, and the power transistor 7, respectively.

Subsequent etching of the underlying thermal oxide 18, followed by removal of the resist, initiates the ion-implantation step with doping of the N type, which is then followed by a thermal diffusion step.

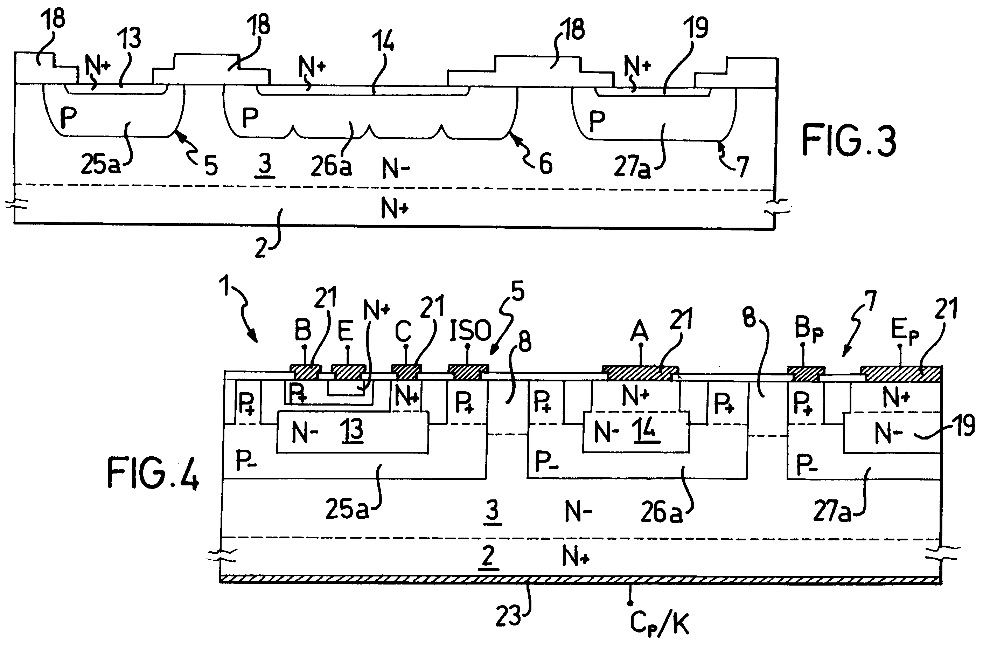

The regions formed with the latter sequence of processing steps are shown in Figures 3 and 4.

The process is then completed by the growth of a second epitaxial layer 8 having the first type of conductivity, the successive definition of the isolation and sink regions, and formation of the base B and emitter E regions for the transistor 7 and the control circuit 5.

The whole is finished with metal contacts 21 on the chip surface and metallization 23 of the opposite surface, as shown in Figure 4.

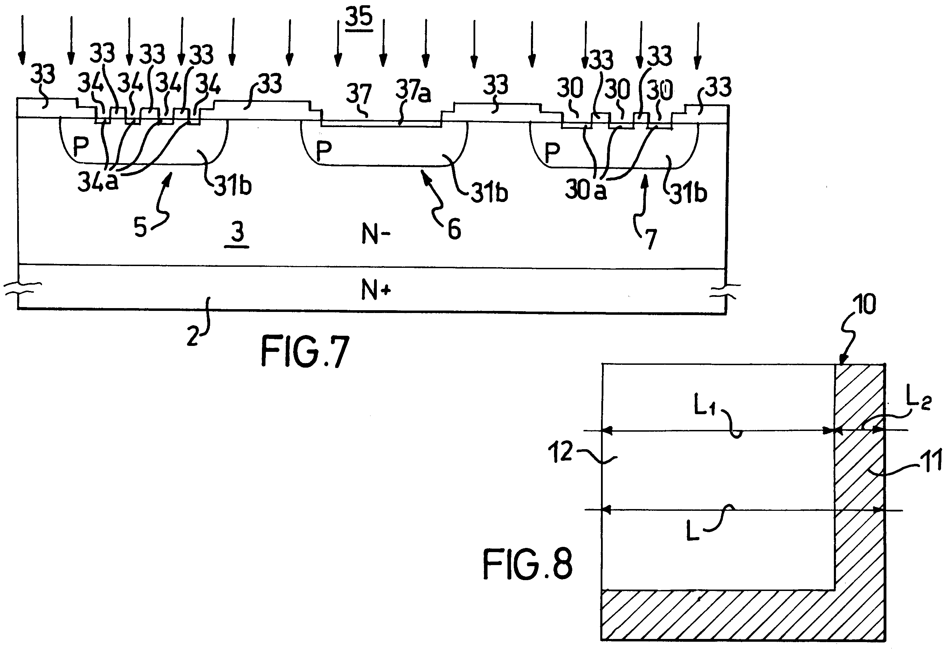

The configuration of a mask used in the first implantation step will now be described with specific reference to the example in Figure 8.

As previously stated, it matters to the invention objectives that, during the ion-implantation step of regions 25, 26 and 27, the area exposed to implantation can be secluded.

An elementary cell 10 is provided for this purpose which is illustrated in Figure 8, merely as an example, by a square surface with side dimension L wherein a second square surface is delimited having a smaller side dimension L1. The second-mentioned surface is, moreover, transparent to the ions being implanted.

Denoting by L2 = L-L1 the difference between the long side L and the short side L1, it becomes easy to find the surface area ratio of the screened or opaque portion 11 of the elementary cell 10 to the exposed or transparent portion 12.

The term "screened" obviously refers here to the property of being impervious to the ions during implantation.

As an example, where a ratio of the exposed area to the overall area is to be two thirds (2/3), i.e.

where an exposed area is sought which is twice as large as the screened area, the parameter L2 only need to be set in order to arrive at the corresponding value of L1 by a simple computation.

In the preferred embodiment being discussed, the values of L2 and L1 have been selected to be 5μm and 22 μm, respectively, so that the ratio of the exposed area to the overall area is actually 66.4%, i.e. two thirds.

The range of application of the technique according to the invention provides for the ratio of the area exposed to ion implantation and the overall area of the elementary cell 10 to vary between two tenths and unity.

Consequently, the ratio of the minimum layer resistivity value to the maximum value will vary within the above range.

It should be understood that the elementary cell 10 is to be associated with more cells of the same type to form a mask for use over the regions to be implanted in accordance with the invention objects.

Therefore, the mask to be used for each individual device to be implanted will comprise an arrey of such elementary cells 10, whose number and size or patterns may vary with the surface area dimension of each individual area.

Further, there is no reason why the pattern of each mask 10 could not be other than that shown, so long as a predetermined ratio can be set at all times of the exposed area transparent to implantation and the overall area.

The above-described embodiment may be altered and changed in many ways within the scope of this invention.

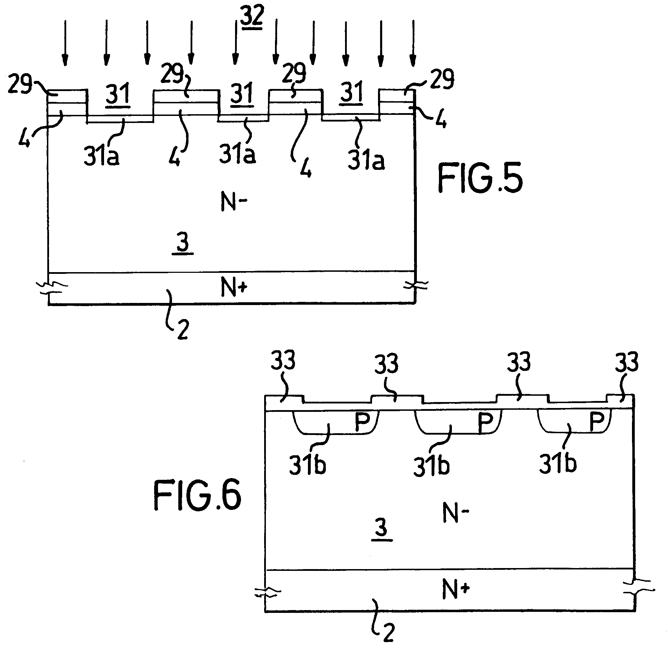

In one of such variations, shown by way of example in Figures 5 to 7, basically similar results, i.e. the same device 1, can be provided by substituting the steps shown in Figures 5 to 7 for those shown in Figures 1 to 3.

In this variation, parts constructed and performing as in the previous embodiment are denoted by the same references.

As shown in Figure 5, a phototechnique step followed by oxide etching enables the implantation of a P-type doping 32 through the apertures 31 cleared of the resist 29 to be initiated.

This allows, in turn, a series of buried layers 31a to be defined which relate to a horizontal isolation region for the driver 5, the base region for the transistor/diode 6, and the base region for the power transistor 7.

Figure 6 illustrates the removal of resist 29 and the thermal diffusion to which the buried layers 31a are subjected to produce the diffused layers 31b. An oxide layer 33 is grown, moreover, on the device 1 surface.

Figure 7 shows the device 1 at the stage when it undergoes a second ion-implantation step using an N-type doping, and after it has gone through a phototechnique and etching step of the oxide 33 to define the apertures 34, 37 and 30.

Such apertures concern the control circuit 5, diode 6, and transistor 7, respectively.

The dose of N-type doping 35 employed in this step varies between $2*10^{14}$ ions/cm2 and $5*10^{15}$ ions/cm2.

Thereafter, a new oxide layer is grown on the device surface, and a heat treatment is applied to diffuse each of the implanted regions 34a, 37a and 30a into respective diffused regions, each uniformly doped.

The structure of the device 1 is completed in quite the same manner as previously described with reference to Figure 4.

Basically, this process variation distinguishes itself by that the P-doped buried regions 31b are formed using the same doping concentration, whereas the aforesaid N-doped regions 34a, 37a and 30a are formed, according to the invention, by implanting a single doping dosage and achieving different concentrations thereof by masking.

In other words, the peculiar screening proposed by the invention is applied to the second implantation step rather than the first.

It will be understood that the process of this invention could also be applied to devices wherein the bipolar power transistor 7 is a pnp type. In this case, it would suffice to exchange all the regions having conductivity of a first type for those having conductivity of a second type.

Furthermore, the above-described technique could be applied simultaneously to both the base and the emitter regions; by so doing, additionally to attaining finer and more accurate control of the device characteristics, the ratio of minimum value to maximum value of the layer resistivity can be extended to one tenth.

Lastly, it should be noted that the process of this invention may also be applied to the npn-type transistors incorporated to the control circuit 5. In this case, the base and emitter regions shown in Figure 4 would be processed simultaneosly.

**Claims**

**1.** A process for forming buried regions, having different doping concentrations, in monolithic semiconductor devices which comprise at least one pair of electronic components incorporating said regions, characterized in that said regions are formed simultaneously by a single phototechnique and implantation operation using partial masking or screening of the respective areas exposed to implantation.

**2.** A process according to Claim 1, characterized in that the different doping concentrations at said regions is univocally set by the ratio of the exposed surface area to the overall surface area of each region.

**3.** A process according to Claim 2, characterized in that said ratio can be controlled between one tenth and unity.

**4.** A process according to Claim 2, characterized in that said ratio is two thirds. 5. A process according to Claim 1, characterized in that said regions are auto-aligned.

**6.** A process according to Claim 1, characterized in that said implantation step provides for the use of one implantation dose.

**7.** A process according to Claim 1, characterized in that, at said regions, the doping is a P type and varies between $1*10^{13}$ ions/cm2 and $3*10^{14}$ ions/cm2,

**8.** A process according to Claim 1, characterized in that said electronic components are a control circuit and/or a high-voltage diode and/or a power transistor.

**9.** A process according to Claim 1, characterized in that it includes a like successive implantation step of a second doping.

**10.** A process according to Claim 9, characterized in that said second doping is an N type and varies between $2*10^{14}$ ions/cm2 and $5*10^{15}$ ions/cm2.

**11.** A process according to Claim 2, characterized in that said buried regions are isolated electrically from one another.

**12.** A process for forming electrically isolated regions from one another having different doping concentrations in monolithic semiconductor devices which comprise at least one pair of electronic components incorporating said regions, characterized in that said regions are formed simultaneously by a single phototechnique and implantation operation using partial masking or screening of the respective areas exposed to the implantation.

**13.** A process according to Claim 12, characterized in that the different doping concentrations at said regions are set univocally by the ratio of the exposed surface area to the overall surface area of each region.

**14.** A process according to Claim 12, characterized in that said regions are auto-aligned.

**FIG.1**

**FIG.2**

EP 0 584 436 A1

EP 0 584 436 A1

**FIG.3**

18   13   18   14   18   19

N+   N+   N+

P   P   P

25a   5   3   26a   N-   6   27a   7

N+

2

**FIG.4**

1   B   21   E   N+   C   21   ISO   5   8   A   21   8   B$_P$   7   E$_P$   21

P+   P+   N+   P+   P+   N+   P+   P+   P+   N+

N-  13   N-  14   N-  19

P-   P-   P-

25a   3   N-   26a   27a

2   N+

23   C$_P$/K

FIG.5

FIG.6

EP 0 584 436 A1

**FIG.7**

**FIG.8**

European Patent Office

**EUROPEAN SEARCH REPORT**

Application Number

EP    92 83 0455

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | US-A-3 976 512 (V. DE NORA ET AL) <br> * the whole document * <br> --- | 1-14 | H01L21/00 <br> H01L21/266 <br> H01L21/74 |
| A | US-A-4 927 772 (S. D. ARTHUR ET AL) <br><br> * column 5, line 36 - column 7, line 43; figures * <br> --- | 1-4,6, 12,13 | |
| A | GB-A-2 078 441 (WESTINGHOUSE ELECTRIC CORP.) <br> * the whole document * <br> --- | 1,12 | |
| A | PATENT ABSTRACTS OF JAPAN <br> vol. 9, no. 298 (E-361)(2021) 26 November 1985 <br> & JP-A-60 137 036 ( MATSUSHITA ELECTRIC INDUSTRIAL CO. ) 20 July 1985 <br> * abstract * <br> --- | 1,12 | |
| A | EP-A-0 145 883 (IBM CORP.) <br> * page 9 - page 10; figures 3A-5B * <br><br> ----- | 1,12 | TECHNICAL FIELDS SEARCHED (Int. Cl.5 ) <br><br> H01L |

The present search report has been drawn up for all claims

| Place of search | Date of completion of the search | Examiner |
|---|---|---|
| BERLIN | 30 APRIL 1993 | ROUSSEL A.T. |

EPO FORM 1503 03.82 (P0401)